# EUROPEAN PATENT APPLICATION

(11) **EP 2 101 162 A2**
(43) Date of publication of application: **16.09.2009**
(21) Application number: 09250671.6
(22) Date of filing: 10.03.2009
(51) Int. Cl.: G01K 17/00

(54) **An adaptor for a meter of the type comprising a meter body and a detector**

(30) Priority: 12.03.2008 GB 0804537
(71) Applicant: Lasermet Limited, Bournemouth Dorset BH9 1HR (GB)
(72) Inventor: Ward, Stuart, Bournemouth, Dorset BH10 6HP (GB)
(74) Representative: Locke, Andrew Robert

(57) **Abstract**

An adaptor is provided for a meter of the type comprising a meter body and a detector. The meter body is operative to process and display an analogue output signal generated by the detector indicative of a given input to the detector. The adaptor comprises electrical connection means operative to form electrical connections with the meter body and with the detector. The adaptor further comprises interface means operative to convert, in use, the analogue output signal from the detector into a standardised output signal for transmission to the meter body.

The interface means can be operative to generate the standardised output signal from a plurality of detectors such that the adapter enables the meter body to be used with more than one detector.

## Description

The present invention relates to an adaptor for a meter of the type comprising a meter body and a detector.

Meters for the measurement of, for example, laser power, are well known and typically comprise a meter body comprising a display unit, a detector being connected to the meter body directly or via a cable. The detector generates an analogue output signal in dependence upon an input to the detector, the input for example being light or heat although such meters can be used to detect any other desired input. The analogue output signal is transmitted unprocessed from the detector to the meter body, via the interconnecting cable if provided. The analogue output signal requires processing prior to being displayed on the meter body for viewing by the meter user and this processing has previously been performed using circuitry inside the meter body, the circuitry being particular to the specific detector being used. It can therefore be difficult to produce a meter body that can be connected to a variety of different sorts of detectors without providing multifunctional circuitry inside the meter body. Such multifunctional circuitry can add significant expense and complexity.

Additionally, if the meter body is to be connectable to a variety of different detectors, processing of the analogue output signal cannot easily be optimised for each individual detector.

Such prior meters can also be subject to other factors such as noise, interference, signal level, and/or bandwidth for example, which may be affected by sending the unprocessed analogue output signal from the detector to the meter body.

According to a first aspect of the invention there is provided an adaptor for a meter of the type comprising a meter body and a detector, the meter body being operative to process and display an analogue output signal generated by the detector indicative of a given input to the detector, the adaptor comprising electrical connection means operative to form electrical connections with the meter body and with the detector, the adaptor further comprising interface means operative to convert, in use, the analogue output signal from the detector into a standardised output signal for transmission to the meter body.

The adaptor may be separate to the detector and meter body.

The interface means may therefore be operative to generate the standardised output signal from a plurality of detectors such that the adapter enables the meter body to be used with more than one detector.

Alternatively the adaptor may be integral with the detector.

The adapter may therefore comprise interface means specific to the particular detector.

Preferably the interface means comprises signal processing circuitry operative to process the analogue output signal from the detector.

The signal processing circuitry may comprise analogue and/or circuitry.

The connection means of the adaptor may comprise a low voltage DC analogue power supply connection to supply power to the analogue circuitry.

The connection means may comprise a supplementary DC digital power supply connection to supply power to the digital circuitry.

Preferably the adaptor comprises a standard serial digital interface.

The adaptor may include a plurality of chip select lines operative to enable signals from serial digital interface devices in at least one of the adaptor and detector to be transmitted to the meter body.

Preferably at least one of the serial digital interface devices comprises a non-volatile storage chip, such as, for example, an EEPROM.

The non-volatile storage chip may store information selected from the group comprising: detector type identity, calibration information, detector serial number, applicable operating parameters, and meter settings appropriate to the detector.

At least one of the serial digital interface devices may comprise an offset null device.

At least one of the serial digital interface devices may comprise a gain trimming device.

Preferably the connection means of the adaptor comprises at least one analogue channel operative to transmit the standardised output signal from the detector.

Preferably the adaptor is for use with a laser power meter.

According to a second aspect of the invention there is provided for a meter of the type comprising a meter body and a detector, the meter body being operative to process and display an analogue output signal generated by the detector indicative of a given input to the detector, the meter being provided with an adaptor comprising electrical connection means operative to form electrical connections with the meter body and with the detector, the adaptor further comprising interface means operative to convert, in use, the analogue output signal from the detector into a standardised output signal for transmission to the meter body.

Preferably the meter comprises a power meter.

Most preferably the meter comprises a laser power meter.

According to a third aspect of the invention there is provided a detector adapted to be connected to for a meter of the type comprising a meter body and a detector, the meter body being operative to process and display an analogue output signal generated by the detector indicative of a given input to the detector, the adaptor comprising electrical connection means operative to form electrical connections with the meter body and detector, the detector being provided with an adaptor further comprising interface means operative to convert, in use, the analogue output signal from the detector into a standardised output signal for transmission to the meter body.

Other aspects of the present invention may include any combination of the features or limitations referred to herein.

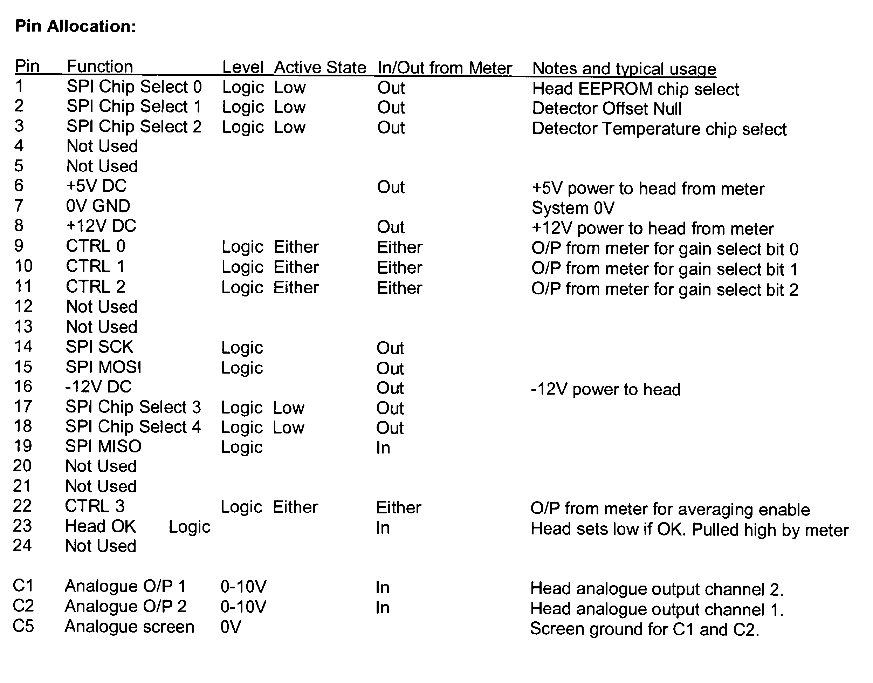

The present invention may be carried into practice in various ways, but embodiments will now be described by way of example only with reference to the accompanying drawing which is a table setting out example connector pin functions for the connection means of an adaptor in accordance with the present invention.

A meter, such as a laser power meter for example, comprises a meter body and a detector connected to the meter body via a signal transmitting cable. The detector is operative to generate an analogue output signal indicative of the power of a given input to the detector.

The meter body comprises meter circuitry to receive and process the output from the detector and to display the processed output as a reading on a display on the meter body.

The power meter further comprises an adaptor which in this example is integral with the detector. The adaptor may alternatively be separate from the detector.

The adaptor comprises connection means to enable the adaptor to be connected to both the meter body and the detector. The connection between the adaptor and the meter body may be via the signal transmitting cable.

The connection means comprises DVI Standard connectors. The signal transmitting cable is fitted with male adaptors with male screwlocks at both ends. The meter body and the detector are fitted with female DVI adaptors with female screwlocks.

The cable connections are equivalent to DVI-I single link standard.

The adaptor comprises interface means comprising signal processing circuitry operative to convert the analogue output signal generated by the detector into a standardised output signal for transmission along the cable to the meter body for processing by the meter circuitry in the meter body.

If the adapter is separate to the detector, the signal processing circuitry may be capable of processing analogue output signals from a plurality of different detectors.

If the adapter is integrated with the detector, the signal processing circuitry may be capable of processing only the particular analogue output signal from the single detector in question.

The standardised output signal is such that whatever detector is used, or whatever detector analogue output signal is generated, the meter circuitry can process it - ie the analogue output signal is converted into a form that is the same regardless of what input is being detected.

The signal processing circuitry in the adaptor may comprise analogue or digital circuitry or a combination of the two.

The adaptor includes sources of power to operate the analogue processing circuitry, the adapter in this example being inside the detector, and + 12V and -12V are provided.

A + 5V supply is also provided to power the digital circuitry. The analogue and digital power supplies share a common ground connection.

The adaptor includes a standard serial digital interface comprising a bi-directional interface (preferably compliant with the SPI standard), together with four chip select lines which allow serial digital interface devices (such as SPI-interface devices) to be included inside the detector. One such device will be a non-volatile storage chip comprising, in this example, an EEPROM which contains the detector identity code to tell the meter which detector is connected. Other information that may be stored in the EEPROM may include calibration information, detector serial number, applicable detector operating parameters and meter settings and other information that may be useful to realise a useful meter.

Other devices that may be included inside the adaptor or detector which utilise the standard serial digital interface, may include offset null or gain trimming devices according to design.

Additional digital signals are included to allow the meter body to control circuitry in the detector, e.g. to select amplification ranges etc.

In general, logic signals are 5V CMOS equivalent.

Analogue signals are 0-10V. The bandwidth will depend on the meter body and detector at each end of the cable. The cable and adaptor should be suitable for bandwidths from DC to 10MHz. In general it is expected that higher bandwidths will be readily achievable.

The adaptor includes two analogue output channels from the detector, although only one is generally used. The meter circuitry is configured to read either input channel.

A Head-OK signal is included, which is used to tell the meter circuitry that a detector is connected and is functioning. Hot-plugging is possible using this signal to detect when a detector is removed or fitted.

In use, the input being detected is received by the detector and an analogue output signal is generated. This analogue output signal is sent to the adaptor and is processed by the signal processing circuitry of the interface means of the adaptor. The signal processing circuitry converts the analogue output signal into a standardised output signal being an analogue output voltage in the range 0 - 10V that can be received, recognised and processed by the standardised meter circuitry in the meter body.

The adaptor thus provides a standardised connection interface between a meter body and a detector such that analogue circuitry dedicated to the specific detector may be incorporated in the adapter, either within or adjacent to the detector, the analogue output signal from the detector being converted by the adapter into a standardised output signal for transmission along the cable to the meter body.

The standardised connection interface means that any detector/adapter which may detect any kind of parameter that it may be desired to measure and which may use different kinds of circuitry, can be connected to existing meter bodies without the need to change the electronic circuitry in the meter body.

The detector used need not therefore necessarily be a light measuring detector.

It is envisaged that existing meter bodies may be adapted to operate with the new detector/adapter by altering the software algorithm of the meter body to suit the new detector/adapter. This could be achieved via a PC for example.

## Claims

1. An adaptor for a meter of the type comprising a meter body and a detector, the meter body being operative to process and display an analogue output signal generated by the detector indicative of a given input to the detector, the adaptor comprising electrical connection means operative to form electrical connections with the meter body and with the detector, the adaptor further comprising interface means operative to convert, in use, the analogue output signal from the detector into a standardised output signal for transmission to the meter body.

2. The adaptor of claim 1 wherein the adaptor is separate to the detector and meter body.

3. The adaptor of claim 1 or 2 wherein the interface means is operative to generate the standardised output signal from a plurality of detectors such that the adapter enables the meter body to be used with more than one detector.

4. The adaptor of claim 1 wherein the adaptor is integral with the detector.

5. The adaptor of claim 4 wherein the adaptor comprises interface means specific to the particular detector.

6. The adaptor of any one of claims 1 to 5 wherein the interface means comprises signal processing circuitry operative to process the analogue output signal from the detector.

7. The adaptor of claim 6 wherein the signal processing circuitry comprises analogue circuitry.

8. The adaptor of claim 6 or claim 7 wherein the signal processing circuitry comprises digital circuitry.

9. The adaptor of any one of claims 1 to 8 wherein the connection means of the adaptor may comprise a low voltage DC analogue power supply connection to supply power to the analogue circuitry.

10. The adaptor of any one of claims 1 to 9 wherein the connection means comprises a supplementary DC digital power supply connection to supply power to the digital circuitry.

11. The adaptor of any one of claims 1 to 10 wherein the adaptor comprises a standard serial digital interface.

12. The adaptor of any one of claims 1 to 11 wherein the adaptor includes a plurality of chip select lines operative to enable signals from serial digital interface devices in at least one of the adaptor and detector to be transmitted to the meter body.

13. The adaptor of claim 12 wherein at least one of the serial digital interface devices comprises a non-volatile storage chip, such as, for example, an EEPROM.

14. The adaptor of claim 13 wherein the non-volatile storage chip is operative to store information selected from the group comprising: detector type identity, calibration information, detector serial number, applicable operating parameters, and meter settings appropriate to the detector.

15. The adaptor of any one of claims 12 to 14 wherein at least one of the serial digital interface devices comprises an offset null device.

16. The adaptor of any one of claims 12 to 15 wherein at least one of the serial digital interface devices comprises a gain trimming device.

17. The adaptor of any one of claims 1 to 16 wherein the connection means of the adaptor comprises at least one analogue channel operative to transmit the standardised output signal from the detector.

18. The adaptor of any one of claims 1 to 17 wherein the adaptor is for use with a laser power meter.

19. A meter of the type comprising a meter body and a detector, the meter body being operative to process and display an analogue output signal generated by the detector indicative of a given input to the detector, the meter being provided with an adaptor comprising electrical connection means operative to form electrical connections with the meter body and with the detector, the adaptor further comprising interface means operative to convert, in use, the analogue output signal from the detector into a standardised output signal for transmission to the meter body.

20. The meter of claim 19 wherein the meter comprises a power meter.

21. The meter of claim 20 wherein the meter comprises a laser power meter.

22. A detector adapted to be connected to a meter of the type comprising a meter body and a detector, the meter body being operative to process and display an analogue output signal generated by the detector indicative of a given input to the detector, the adaptor comprising electrical connection means operative to form electrical connections with the meter body and detector, the detector being provided with an adaptor further comprising interface means operative to convert, in use, the analogue output signal from the detector into a standardised output signal for transmission to the meter body.
